# EUROPEAN PATENT APPLICATION

(11) **EP 4 826 451 A1**
(43) Date of publication of application: **21.10.2026**
(21) Application number: 24903672.4
(22) Date of filing: 10.12.2024
(51) Int. Cl.: G03F 7/11, C08G 59/17, G03F 7/20, H01L 21/027

(54) **COMPOSITION FOR FORMING RESIST UNDERLAYER FILM**

(30) Priority: 11.12.2023 JP 2023208315
(71) Applicant: Nissan Chemical Corporation, Tokyo 103-6119 (JP)
(72) Inventor: IGATA, Kosuke, Toyama-shi, Toyama 939-2792 (JP); TAMURA, Mamoru, Toyama-shi, Toyama 939-2792 (JP)
(74) Representative: Hoffmann Eitle
(86) International application number: PCT/JP2024/043557
(87) International publication number: WO 2025/127018

(57) **Abstract**

A resist underlayer film-forming composition including a resin (A) having a ring structure and a polymerizable multiple-bond group and a solvent, wherein the ring structure is one or more selected from the group consisting of an aromatic ring having 6 to 26 carbon atoms and a non-aromatic ring having 6 to 10 carbon atoms, and the polymerizable multiple-bond group has one or more selected from the group consisting of a carbon-carbon double bond, a carbon-carbon triple bond, a carbon-nitrogen double bond, and a carbon-nitrogen triple bond.

## Description

### Technical Field

The present invention relates to a resist underlayer film-forming composition, a resist underlayer film, a laminate, a method for producing a semiconductor element, and a method for forming a pattern.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. Along with this, a resist pattern formation defect due to the influence from a semiconductor substrate or the like becomes a major problem. Therefore, in order to solve this problem, a method of providing a resist underlayer film between a resist and a semiconductor substrate has been widely studied.

Patent Literature 1 discloses an underlayer film-forming composition for lithography containing a naphthalene ring having a halogen atom. Patent Literature 2 discloses a halogenated antireflective film. Patent Literature 3 discloses a resist underlayer film-forming composition.

### Citation List

### Patent Literature

Patent Literature 1: WO 2006/003850 A
Patent Literature 2: JP 2005-526270 A
Patent Literature 3: WO 2020/111068 A

### Summary of Invention

### Technical Problem

Examples of the characteristics required for the resist underlayer film include a characteristic allowing for the formation of a resist pattern with high sensitivity and a characteristic allowing for the formation of a resist pattern having small roughness (line width roughness (LWR)).

The present invention has been made in view of the above circumstances, and an object of the present invention is to provide a resist underlayer film-forming composition allowing for the formation of a resist pattern with high sensitivity without deteriorating roughness, and a resist underlayer film, a laminate, a method for producing a semiconductor element, and a method for forming a pattern, for all of which the resist underlayer film-forming composition is used.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition including a resin (A) having a ring structure and a polymerizable multiple-bond group and a solvent, wherein
   the ring structure is one or more selected from the group consisting of an aromatic ring having 6 to 26 carbon atoms and a non-aromatic ring having 6 to 10 carbon atoms, and
   the polymerizable multiple-bond group has one or more selected from the group consisting of a carbon-carbon double bond, a carbon-carbon triple bond, a carbon-nitrogen double bond, and a carbon-nitrogen triple bond.
[2] The resist underlayer film-forming composition according to [1], wherein in the resin (A), the polymerizable multiple-bond group is bonded to the ring structure by a reaction between an epoxy group and a nucleophilic functional group.
[3] The resist underlayer film-forming composition according to [2], wherein the nucleophilic functional group is one or more selected from the group consisting of a carboxy group, a hydroxy group, an amino group, and a thiol group.
[4] The resist underlayer film-forming composition according to any one of [1] to [3], wherein the resin (A) includes at least one of a partial structure represented by Formula (1) as a partial structure having the polymerizable multiple-bond group, or a partial structure represented by Formula (2) or (3) as a partial structure having the ring structure and the polymerizable multiple-bond group. 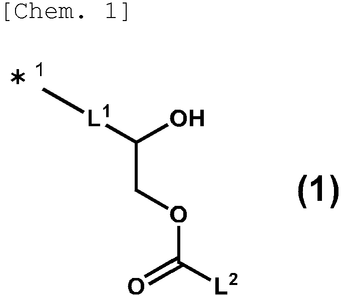 wherein L¹ represents a single bond, -O-CH₂-, -CH₂-O-, -CH₂-O-CH₂-, -CH₂-O-CO-, or -CO-O-CH₂-, L² represents a monovalent polymerizable multiple-bond group, and *¹ represents a bond that is bonded to the ring structure. 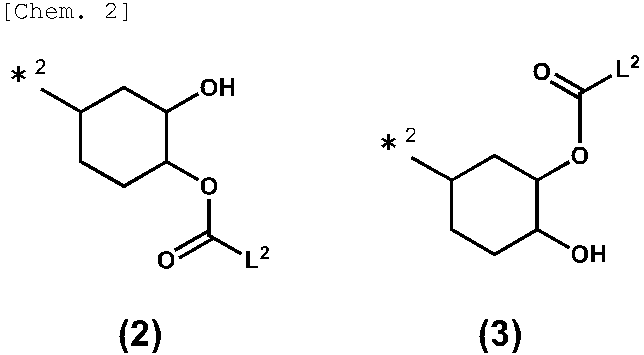 wherein L² represents a monovalent polymerizable multiple-bond group, and *² represents a bond.
[5] The resist underlayer film-forming composition according to [4], wherein L² is an alkenyl group having 3 to 5 carbon atoms or a hydrocarbon group having 4 to 5 carbon atoms and having two carbon-carbon double bonds.
[6] The resist underlayer film-forming composition according to any one of [1] to [5], further including a crosslinking agent.
[7] The resist underlayer film-forming composition according to any one of [1] to [6], further including an acid generator.
[8] A resist underlayer film that is a cured product of the resist underlayer film-forming composition according to any one of [1] to [7].
[9] A laminate including:
   a semiconductor substrate; and
   the resist underlayer film according to [8].
[10] A method for producing a semiconductor element, the method including the steps of:
   forming a resist underlayer film on a semiconductor substrate using the resist underlayer film-forming composition according to any one of [1] to [7]; and
   forming a resist film on the resist underlayer film.
[11] A method for forming a pattern, the method including the steps of:
   forming a resist underlayer film on a semiconductor substrate using the resist underlayer film-forming composition according to any one of [1] to [7];
   forming a resist film on the resist underlayer film;
   irradiating the resist film with light or an electron beam, and then developing the resist film to obtain a resist pattern; and
   etching the resist underlayer film using the resist pattern as a mask.

### Advantageous Effects of Invention

According to the present invention, it is possible to provide a resist underlayer film-forming composition allowing for the formation of a resist pattern with high sensitivity without deteriorating roughness, and a resist underlayer film, a laminate, a method for producing a semiconductor element, and a method for forming a pattern, for all of which the resist underlayer film-forming composition is used.

### Description of Embodiments

### (Resist Underlayer Film-Forming Composition)

The resist underlayer film-forming composition of the present invention contains a resin (A) and a solvent.

### <Resin (A)>

The resin (A) has a ring structure and a polymerizable multiple bond.

The ring structure is one or more selected from the group consisting of an aromatic ring having 6 to 26 carbon atoms and a non-aromatic ring having 6 to 10 carbon atoms.

The polymerizable multiple bond is one or two or more polymerizable multiple bonds selected from the group consisting of a carbon-carbon double bond, a carbon-carbon triple bond, a carbon-nitrogen double bond, and a carbon-nitrogen triple bond.

The resin (A) is an organic compound.

The resin (A) may be a polymer.

The resin (A) has, for example, a (meth)acryloyl group, a vinylaryl group (for example, a styryl group), a vinyloxy group, or an allyl group as a group having a polymerizable multiple bond in a side chain.

The resin (A) is, for example, a resin (A-1) having a group having a polymerizable multiple bond in a side chain of a novolac resin. The resin (A) is, for example, a resin (A-2) having a group having a polymerizable multiple bond in a side chain of a ring-opened polymer of an alicyclic epoxy compound.

Examples of the group having a polymerizable multiple bond include a (meth)acryloyl group, a vinylaryl group (for example, a styryl group), a vinyloxy group, and an allyl group.

For example, in the resin (A), the polymerizable multiple bond is bonded to the ring structure of the resin (A) by a reaction between an epoxy group and a nucleophilic functional group.

Examples of the nucleophilic functional group include one or two or more selected from the group consisting of a carboxy group, a hydroxy group, an amino group, and a thiol group. The hydroxy group may be a phenolic hydroxy group, or need not be a phenolic hydroxy group.

When an epoxy group reacts with a carboxy group, the following reaction occurs to form the following structure (S1): 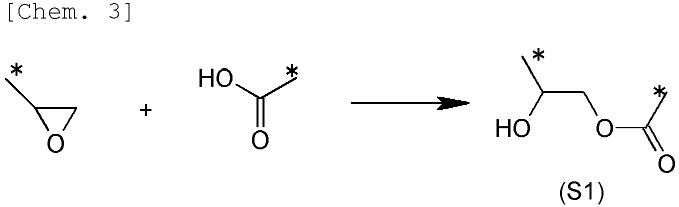 wherein * represents a bond.

The ring structure of the resin (A) is, for example, one or more selected from the group consisting of an aromatic ring having 6 to 26 carbon atoms and a non-aromatic ring having 6 to 10 carbon atoms.

The aromatic ring may be a single ring, a linked ring, or a fused ring.

The number of carbon atoms of the aromatic ring is 6 to 26, preferably 6 to 18, and more preferably 6 to 12.

Examples of the aromatic ring include a benzene ring, a naphthalene ring, an anthracene ring, a phenanthrene ring, a fluorene ring, and rings in which these rings are linked or fused to each other, and a benzene ring and a naphthalene ring are preferable.

Examples of the non-aromatic ring include non-aromatic hydrocarbon rings, such as a cyclohexane ring, a cycloheptane ring, a cyclooctane ring, a cyclononane ring, a cyclodecane ring, and a ring derived from norbornene, and a cyclohexane ring is preferable.

The resin (A) preferably has a partial structure represented by Formula (1): 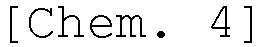 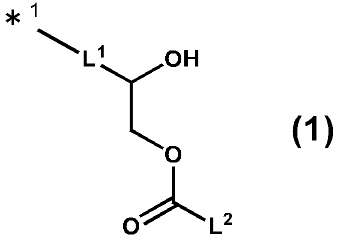 wherein L¹ represents a single bond, -O-CH₂-, -CH₂-O-, -CH₂-O-CH₂-, -CH₂-O-CO-, or -CO-O-CH₂-, L² represents a monovalent polymerizable multiple-bond group, and *¹ represents a bond that is bonded to the ring structure.

The resin (A) may have a partial structure represented by Formula (2) or (3): 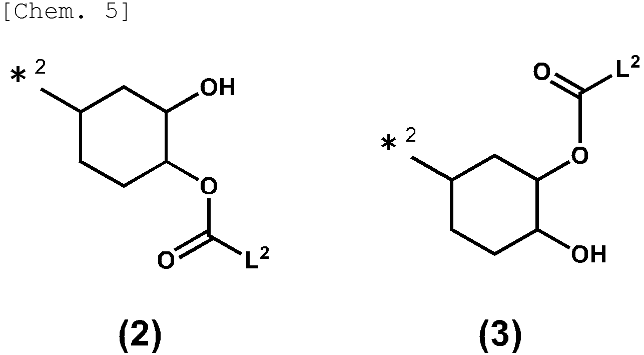 wherein L² represents a monovalent polymerizable multiple-bond group, and *² represents a bond.

L² is a monovalent group having a polymerizable multiple bond. The monovalent group may be a polymerizable multiple bond itself.

The number of carbon atoms of the monovalent group is not particularly limited, and may be, for example, 1 to 20 or 1 to 10.

L² is preferably, for example, an alkenyl group having 3 to 5 carbon atoms or a hydrocarbon group having 4 to 5 carbon atoms and having two carbon-carbon double bonds.

Examples of L² include the following monovalent groups (L2-1) to (L2-32): 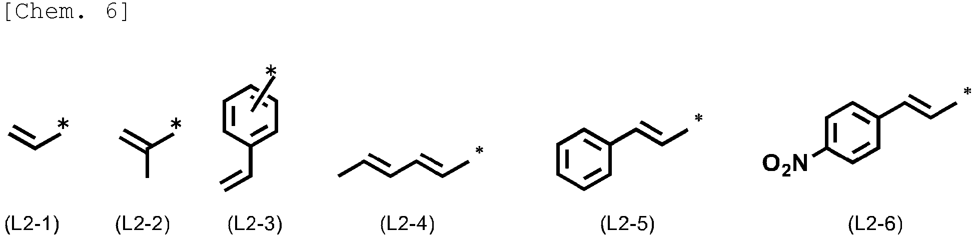 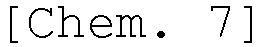 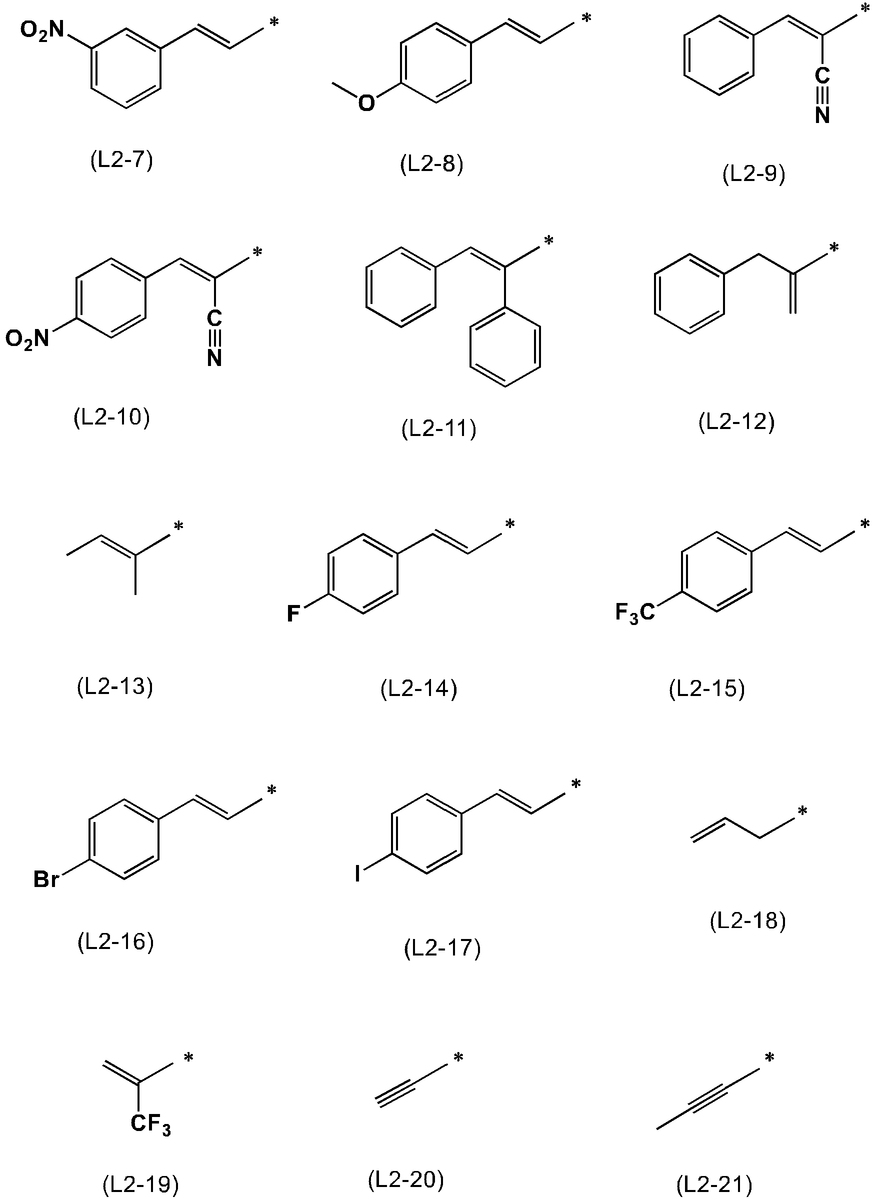 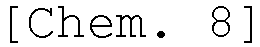 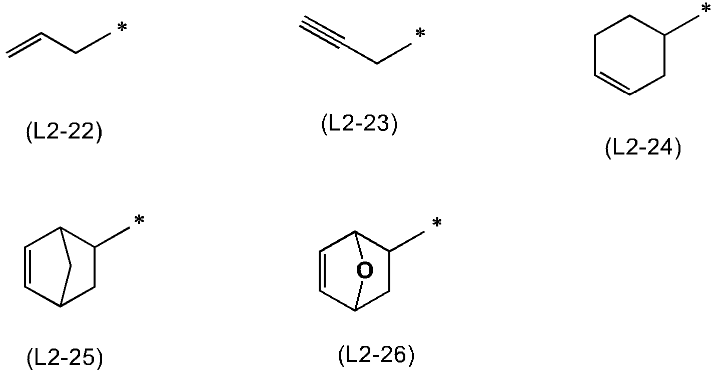 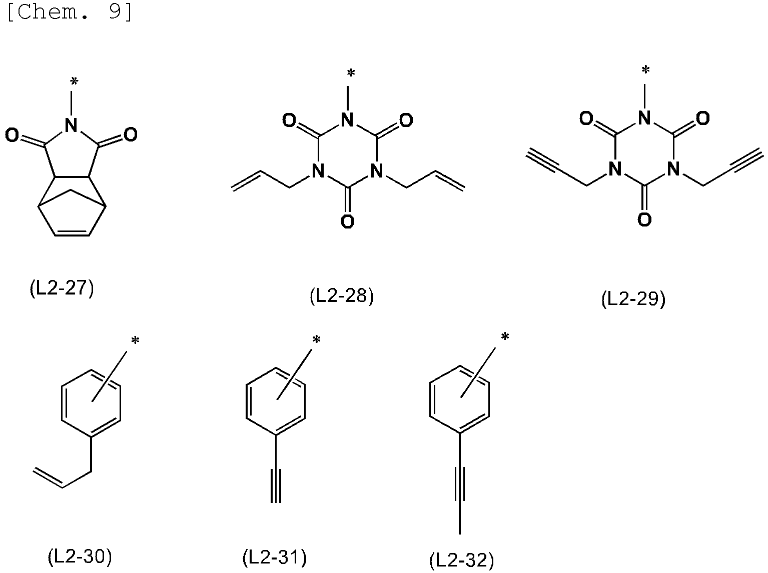 wherein * represents a bond.

An example of the resin (A) can be obtained, for example, by reacting a compound (C1) having a polymerizable multiple bond and a carboxy group with an epoxy group-containing compound (E) as described below. Examples of the epoxy group-containing compound (E) include benzene substituted with a group having an epoxy group, alicyclic hydrocarbon substituted with a group having an epoxy group, and derivatives thereof. The compound (E1) of the following formula is an example of a derivative of benzene substituted with a group having an epoxy group. The compound (E2) of the following formula is an example of a derivative of an alicyclic hydrocarbon substituted with a group having an epoxy group. 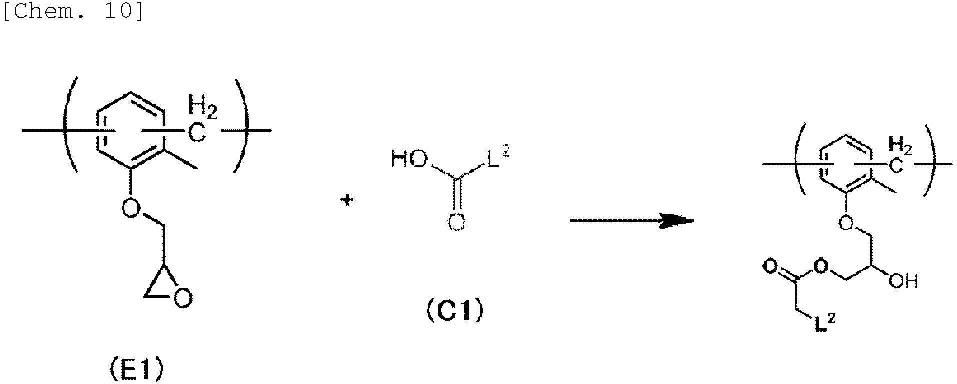 wherein L² is as defined for L² in Formula (1). 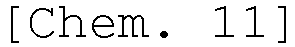 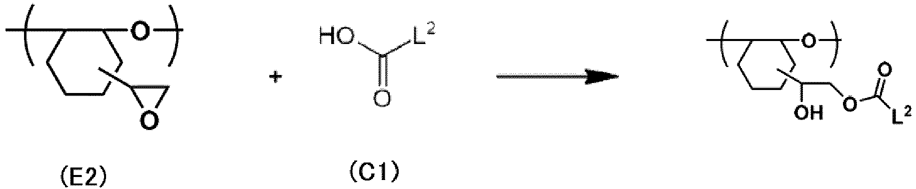 wherein L² is as defined for L² in Formula (1).

The reaction can be performed, for example, in the presence of a catalyst such as tetrabutylphosphonium bromide.

Examples of the epoxy group-containing compound (E) include compounds having the following structural unit and compounds having the following structure: 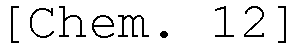 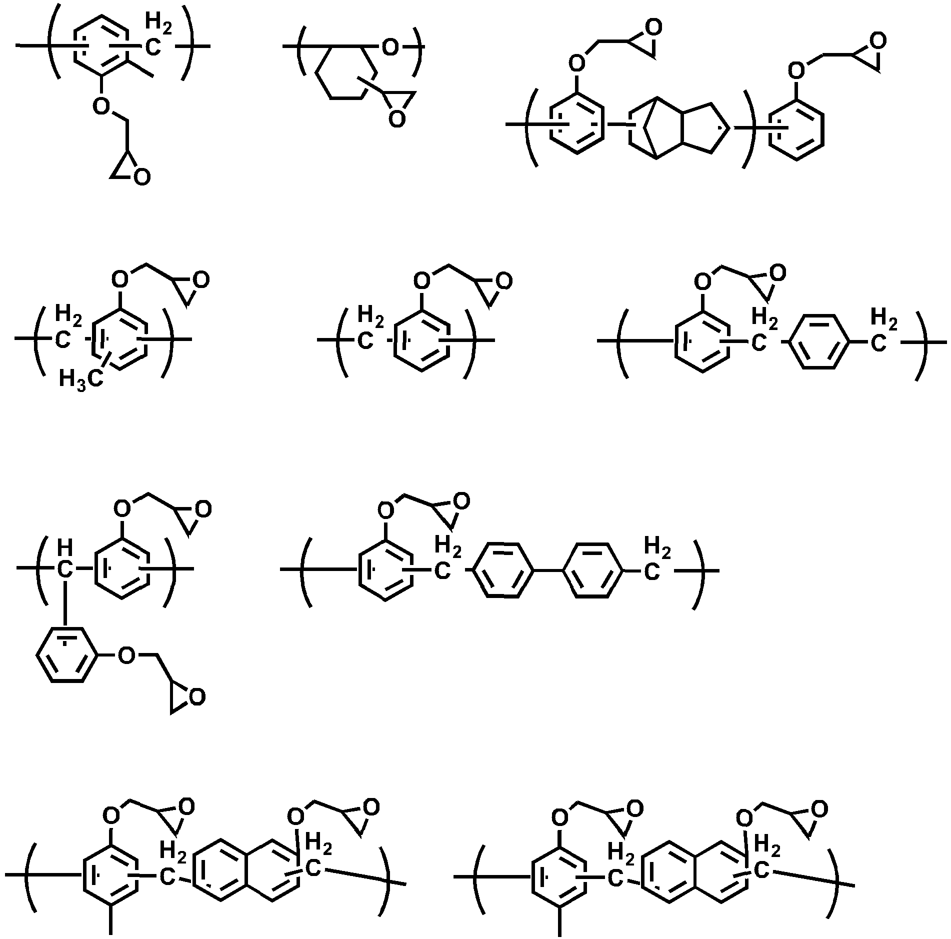 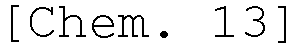 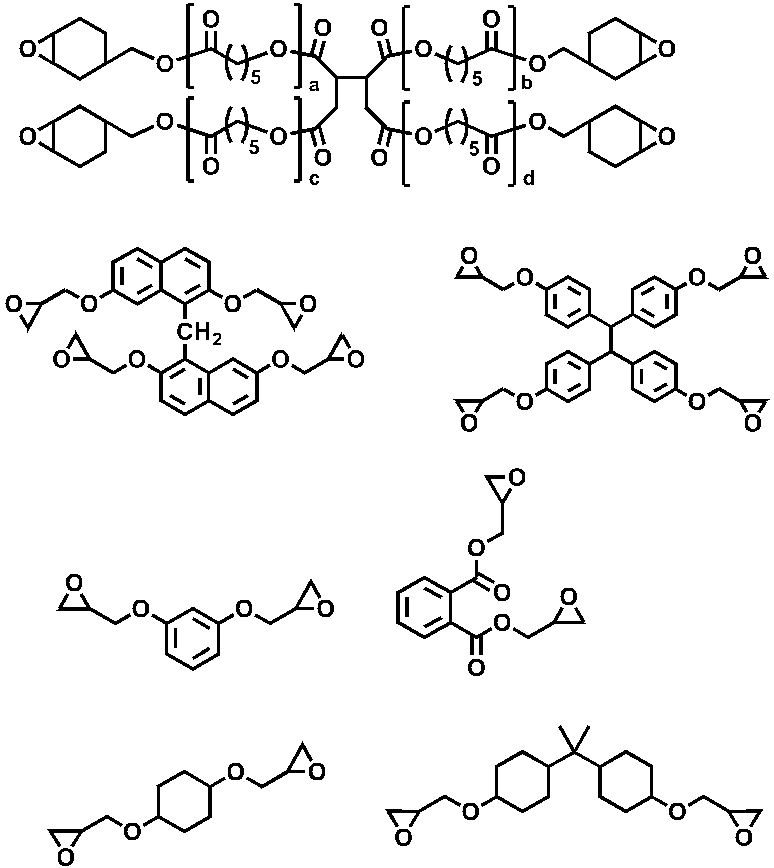 wherein a, b, c, and d each independently represent an integer of 0 to 30.

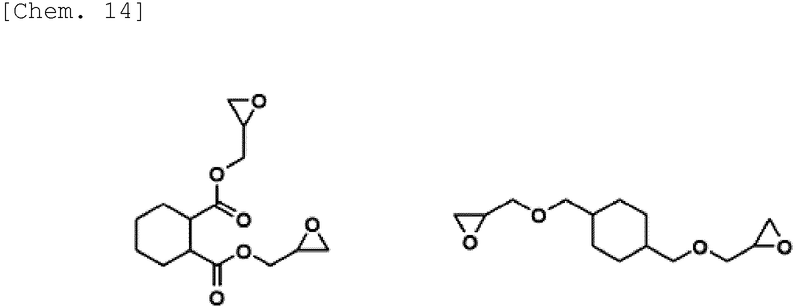

Examples of the compound (C1) having a polymerizable multiple bond and a carboxy group include acrylic acid, methacrylic acid, 4-vinylbenzoic acid, sorbic acid, tetrolic acid, tiglic acid, 1-cyclohexene-1-carboxylic acid, 2-benzylacrylic acid, trans-cinnamic acid, trans-4-methoxycinnamic acid, α-phenylcinnamic acid, monomethyl fumarate, α-cyanocinnamic acid, 4-nitrocinnamic acid, and 3-nitrocinnamic acid.

The resin (A) is, for example, not a polysiloxane.

The resin (A) is, for example, not a hydrolytic condensate of a hydrolyzable silane.

The resin (A) is, for example, not a reaction product of a tetracarboxylic dianhydride and a diepoxy compound having two epoxy groups.

The resin (A) is, for example, not a reaction product of a tetracarboxylic dianhydride, a diepoxy compound having two epoxy groups, and a monohydroxy compound having one hydroxy group.

The resin (A), for example, does not have an isocyanuric acid skeleton having an alkenyl group. Examples of the alkenyl group include alkenyl groups having 3 to 6 carbon atoms. Examples of the alkenyl group having 3 to 6 carbon atoms include an allyl group.

The content of the resin (A) in the resist underlayer film-forming composition is, for example, preferably 50 to 100 mass% and more preferably 70 to 95 mass% with respect to the mass of the film-forming components.

Here, the film-forming components refer to components excluding the solvent component from the resist underlayer film-forming composition.

The molecular weight of the resin (A) is not particularly limited.

The lower limit of the weight-average molecular weight of the resin (A) is, for example, 500, 1,000, 2,000, or 3,000.

The upper limit of the weight-average molecular weight of the resin (A) is, for example, 100,000, 50,000, 30,000, 20,000, or 10,000.

### <Solvent>

The solvent to be used in the resist underlayer film-forming composition is not particularly limited as long as it is a solvent that can uniformly dissolve components contained in the resin (A) or the like, and an organic solvent generally used in a chemical for a semiconductor lithography process is preferred. Specific examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide. These solvents can be used singly, or in combination of two or more kinds thereof.

Among these solvents, propylene glycol monomethyl ether, propylene glycol monomethyl ether acetate, ethyl lactate, butyl lactate, methyl 2-hydroxyisobutyrate, and cyclohexanone are preferable. In particular, propylene glycol monomethyl ether and propylene glycol monomethyl ether acetate are preferable.

### <Acid Generator>

As the acid generator contained as an optional component in the resist underlayer film-forming composition, both a thermal acid generator and a photo acid generator can be used. Preferably, the thermal acid generator is used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonic acid, pyridinium-p-hydroxybenzenesulfonic acid (p-phenolsulfonic acid pyridinium salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photo acid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoro-n-butanesulfonate, diphenyliodonium perfluoro-n-octanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoro-n-butanesulfonate, triphenylsulfonium camphorsulfonate, and triphenylsulfonium trifluoromethanesulfonate.

Examples of the sulfonimide compounds include N-(trifluoromethanesulfonyloxy)succinimide, N-(nonafluoro-n-butanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

The acid generators can be used singly, or in combination of two or more kinds thereof.

When an acid generator is used, the content ratio of the acid generator is, for example, 0.1 mass% to 50 mass%, preferably 1 mass% to 30 mass% with respect to the crosslinking agent.

### <Crosslinking Agent>

The crosslinking agent is not particularly limited.

Examples of the crosslinking agent include compounds having two or more of the following structures: 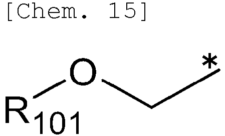 wherein R₁₀₁ represents a hydrogen atom, an alkyl group having 1 to 4 carbon atoms, or an alkoxyalkyl group having 2 to 6 carbon atoms, and * represents a bond.

The bond is bonded to, for example, a nitrogen atom, a carbon atom constituting an aromatic hydrocarbon ring, or the like.

R₁₀₁ is preferably a hydrogen atom, a methyl group, an ethyl group, or a group represented by the following structure: 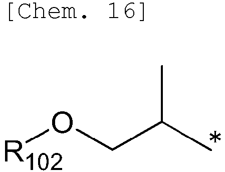 wherein R₁₀₂ represents a hydrogen atom, a methyl group, or an ethyl group, and * represents a bond.

The crosslinking agent is preferably a melamine compound, a guanamine compound, a glycoluril compound, a urea compound, or a compound having a phenolic hydroxy group. These compounds can be used singly, or in combination of two or more kinds thereof.

The melamine compound is not particularly limited as long as it is a melamine compound having a group that can react with a hydroxy group.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

The guanamine compound is not particularly limited as long as it is a guanamine compound having a group that can react with a hydroxy group.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

The glycoluril compound is not particularly limited as long as it is a glycoluril compound having a group that can react with a hydroxy group.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by Formula (1E): 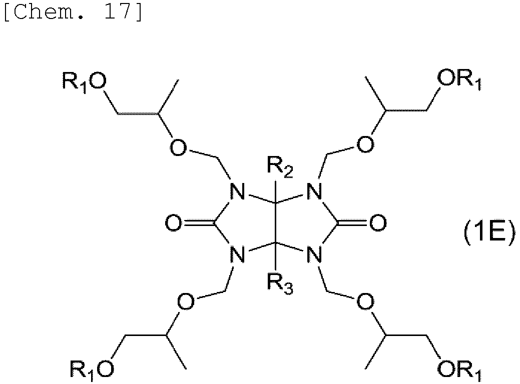 wherein four R₁ groups each independently represent a methyl group or an ethyl group, and R₂ and R₃ each independently represent a hydrogen atom, an alkyl group having 1 to 4 carbon atoms, or a phenyl group.

Examples of the glycoluril derivative represented by Formula (1E) include compounds represented by Formulae (1E-1) to (1E-6).

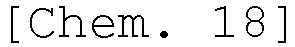

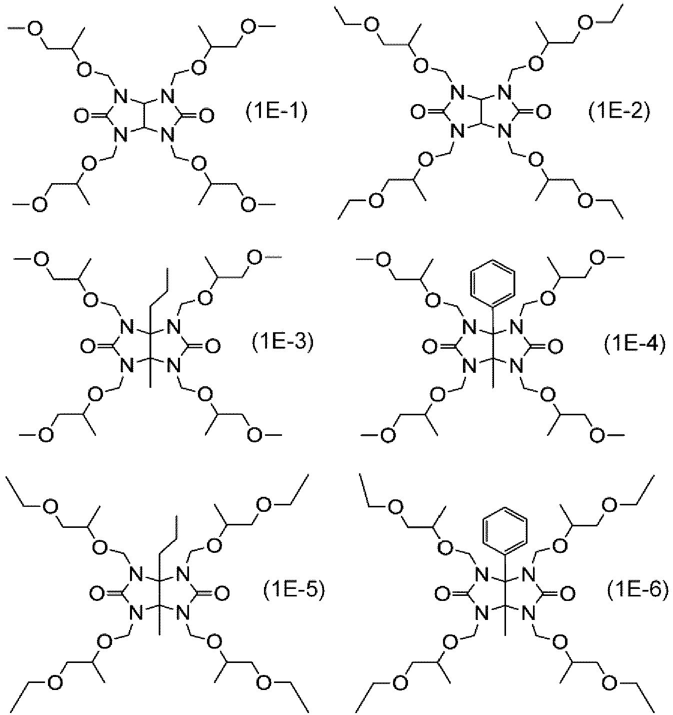

The glycoluril derivative represented by Formula (1E) is obtained, for example, by reacting a glycoluril derivative represented by Formula (2E) with at least one compound represented by Formula (3d). 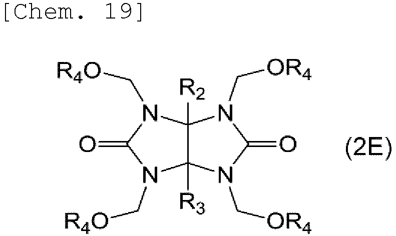 wherein R₂ and R₃ each independently represent a hydrogen atom, an alkyl group having 1 to 4 carbon atoms, or a phenyl group, and each R₄ independently represents an alkyl group having 1 to 4 carbon atoms. 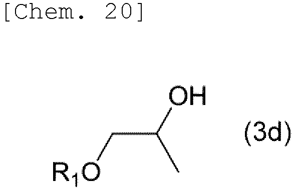 wherein R₁ represents a methyl group or an ethyl group.

Examples of the glycoluril derivative represented by Formula (2E) include compounds represented by Formulae (2E-1) to (2E-4). Further, examples of the compound represented by Formula (3d) include compounds represented by Formula (3d-1) and Formula (3d-2).

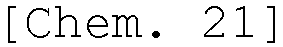

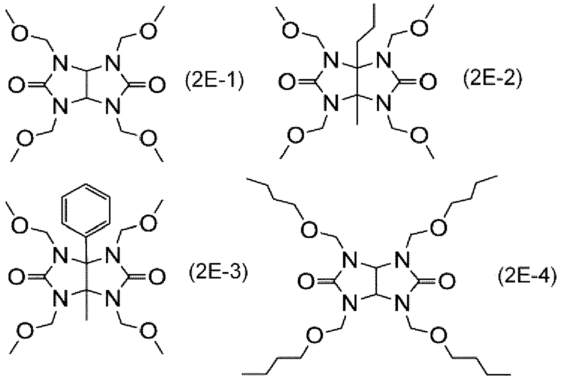

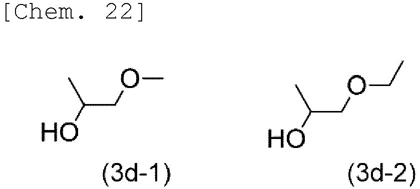

The urea compound is not particularly limited as long as it is a urea compound having a group that can react with a hydroxy group.

Examples of the urea compound include tetramethylol urea, tetramethoxymethyl urea, a compound in which 1 to 4 methylol groups of tetramethylol urea are methoxymethylated or a mixture thereof, and tetramethoxyethyl urea.

Examples of the compound having a phenolic hydroxy group include compounds represented by Formula (111) or (112): 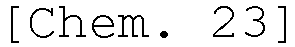 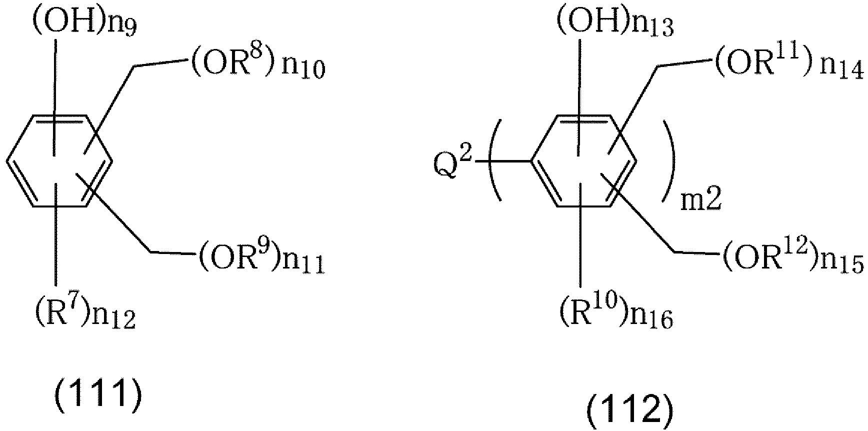
wherein Q² represents a single bond or an m2-valent organic group,
R⁸, R⁹, R¹¹, and R¹² each represent a hydrogen atom or a methyl group,
R⁷ and R¹⁰ each represent an alkyl group having 1 to 10 carbon atoms or an aryl group having 6 to 40 carbon atoms,
n₉ represents an integer that satisfies 1 ≤ n₉ ≤ 3, n₁₀ represents an integer that satisfies 2 ≤ n₁₀ ≤ 5, n₁₁ represents an integer that satisfies 0 ≤ n₁₁ ≤ 3, n₁₂ represents an integer that satisfies 0 ≤ n₁₂ ≤ 3, and n₉ + n₁₀ + n₁₁ + n₁₂ represents an integer that satisfies 3 ≤ (n₉ + n₁₀ + n₁₁ + n₁₂) ≤ 6,
n₁₃ represents an integer that satisfies 1 ≤ n₁₃ ≤ 3, n₁₄ represents an integer that satisfies 1 ≤ n₁₄ ≤ 4, n₁₅ represents an integer that satisfies 0 ≤ n₁₅ ≤ 3, n₁₆ represents an integer that satisfies 0 ≤ n₁₆ ≤ 3, and n₁₃ + n₁₄ + n₁₅ + n₁₆ represents an integer that satisfies 2 ≤ (n₁₃ + n₁₄ + n₁₅ + n₁₆) ≤ 5, and
m2 represents an integer of 2 to 10.

Examples of the m2-valent organic group in Q² include an m2-valent organic group having 1 to 4 carbon atoms.

Examples of the compound represented by Formula (111) or (112) include the following compounds.

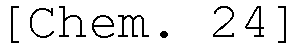

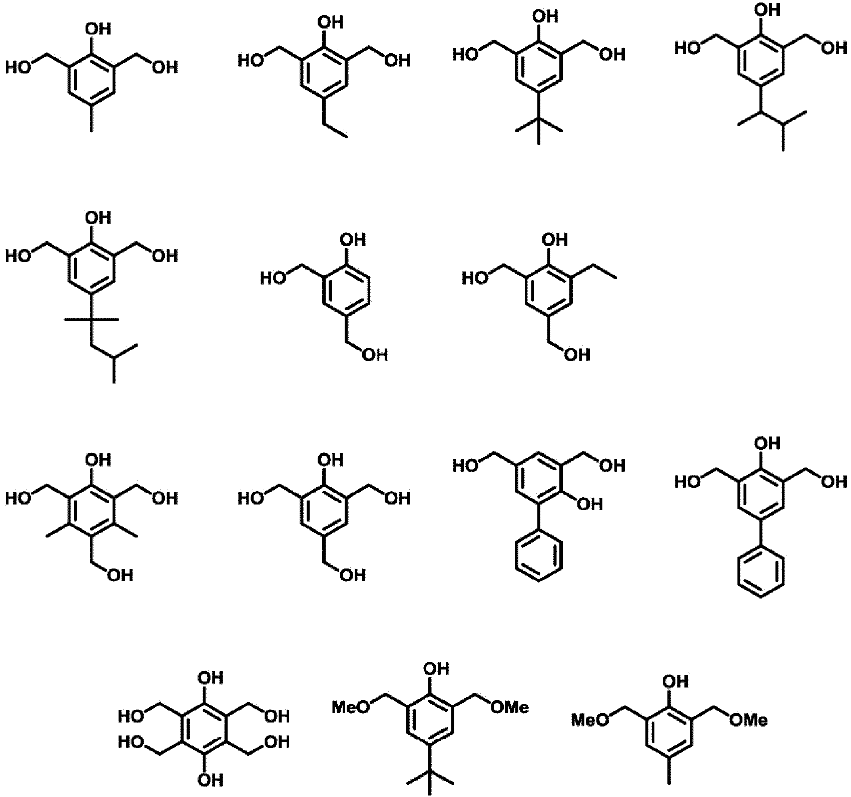

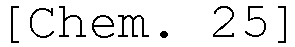

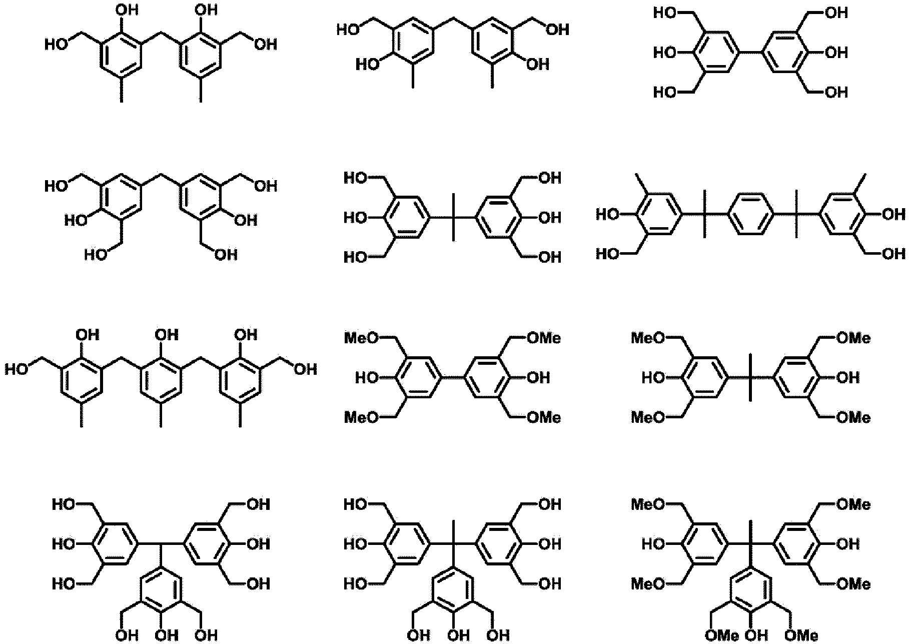

The compounds are available as products of ASAHI YUKIZAI CORPORATION and Honshu Chemical Industry Co., Ltd. Examples of the product include TMOM-BP (trade name) of

### ASAHI YUKIZAI CORPORATION.

Among them, the glycoluril compound is preferable. Specifically, tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof are preferable, and tetramethoxymethylglycoluril is preferable.

The molecular weight of the crosslinking agent is not particularly limited, but is preferably 500 or less.

The content of the crosslinking agent in the resist underlayer film-forming composition is not particularly limited, and is, for example, 1 mass% to 50 mass%, preferably 5 mass% to 40 mass% with respect to the resin (A).

### <Thermal Radical Polymerization Initiator>

The polymerizable multiple bond of the resin (A), for example, polymerizes upon heating even in the absence of a thermal radical polymerization initiator. Accordingly, the resist underlayer film-forming composition need not contain a thermal radical polymerization initiator.

Polymerization of the polymerizable multiple bond may be initiated by radicals generated from thermal decomposition of a polymer, a solvent, additives such as a crosslinking agent in the composition or impurities contained therein.

The resist underlayer film-forming composition not containing a thermal radical polymerization initiator has excellent storage stability as compared with the resist underlayer film-forming composition containing a thermal radical polymerization initiator. Thus, it is preferable that the content ratio of the thermal radical polymerization initiator in the resist underlayer film-forming composition is small. The content ratio of the thermal radical polymerization initiator in the resist underlayer film-forming composition is preferably 0 mass% to 1 mass%, more preferably 0 mass% to 0.5 mass%, and particularly preferably 0 mass% to 0.1 mass% with respect to the resin (A).

Examples of the thermal radical polymerization initiator include peroxides, azo-based compounds, and persulfates.

Examples of the peroxides include acetyl peroxide, benzoyl peroxide, methyl ethyl ketone peroxide, cyclohexanone peroxide, hydrogen peroxide, tert-butyl hydroperoxide, cumene hydroperoxide, di-tert-butyl peroxide, dicumyl peroxide, dilauroyl peroxide, tert-butyl peroxyacetate, tert-butyl peroxypivalate, and tert-butyl peroxy-2-ethylhexanoate (tert-butyl 2-ethylhexaneperoxoate).

Examples of the azo-based compounds include 2,2'-azobisisobutyronitrile, 2,2'-azobis(2,4-dimethylvaleronitrile), (1-phenylethyl)azodiphenylmethane, 2,2'-azobis(4-methoxy-2,4-dimethylvaleronitrile), dimethyl 2,2'-azobisisobutyrate, 2,2'-azobis(2-methylbutyronitrile), 1,1'-azobis(1-cyclohexanecarbonitrile), 2-(carbamoylazo)isobutyronitrile, 2,2'-azobis(2,4,4-trimethylpentane), 2-phenylazo-2,4-dimethyl-4-methoxyvaleronitrile, and 2,2'-azobis(2-methylpropane).

Examples of the persulfates include ammonium persulfate, sodium persulfate, and potassium persulfate.

The thermal radical polymerization initiator may be a commercially available product.

### <Other Components>

To the resist underlayer film-forming composition, a surfactant can be further added in order to further improve the coatability for surface unevenness without generating a pinhole, a striation, and the like.

Further, any polymer other than the resin (A) can be added. Examples thereof include a polymer described in WO 2013/018802 A and a polymer containing hydroxyarene.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl aryl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tohkem Products Corp.), MEGAFACE F171, F173, and R-30 (trade name, manufactured by DIC Corporation), Fluorad FC430 and FC431 (trade name, manufactured by Sumitomo 3M Limited), AsahiGuard AG710, Surflon S-382, SC101, SC102, SC103, SC104, SC105, and SC106 (trade name, manufactured by AGC Inc.), and an organosiloxane polymer KP341 (manufactured by Shin-Etsu Chemical Co., Ltd.).

The blending amount of such a surfactant is typically 2.0 mass% or less, and preferably 1.0 mass% or less with respect to the total solid content of the resist underlayer film-forming composition.

These surfactants can also be added singly, or in combination of two or more kinds thereof.

The solid content (that is, the components excluding the solvent) in the resist underlayer film-forming composition of the present invention is, for example, 0.01 mass% to 10 mass%.

### (Resist Underlayer Film)

The resist underlayer film of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate onto which the resist underlayer film-forming composition is applied include silicon wafers, germanium wafers, and compound semiconductor wafers of gallium arsenide, indium phosphide, gallium nitride, indium nitride, aluminum nitride, and the like.

In the case of using a semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate by an appropriate application method using a spinner, a coater, or the like. Thereafter, baking is performed using a heating means such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present description is as follows.
· Measurement apparatus name: Ellipsometric Film Thickness Measurement System RE-3100 (SCREEN Semiconductor Solutions Co., Ltd.)
· Single wavelength ellipsometer (SWE) mode
· Arithmetic average of 8 points (for example, 8-point measurement at intervals of 1 cm in a wafer-X direction)

### (Laminate)

The laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Method for Producing Semiconductor Element and Method for Forming Pattern)

The method for producing a semiconductor element of the present invention includes at least the following steps.
· Step of forming a resist underlayer film on a semiconductor substrate using the resist underlayer film-forming composition of the present invention
· Step of forming a resist film on the resist underlayer film

The method for forming a pattern of the present invention includes at least the following steps.
· Step of forming a resist underlayer film on a semiconductor substrate using the resist underlayer film-forming composition of the present invention
· Step of forming a resist film on the resist underlayer film
· Step of irradiating the resist film with light or an electron beam, and then developing the resist film to obtain a resist pattern
· Step of etching the resist underlayer film using the resist pattern as a mask

The resist layer is typically formed on the resist underlayer film.

The film thickness of the resist layer is preferably 200 nm or less, more preferably 150 nm or less, still more preferably 100 nm or less, and particularly preferably 80 nm or less. The film thickness of the resist layer is preferably 10 nm or more, more preferably 20 nm or more, and particularly preferably 30 nm or more.

The resist film formed on the resist underlayer film by a known method (for example, applying and baking of resist) is not particularly limited as long as it responds to light or an electron beam (EB) used for irradiation. Both a negative photoresist and a positive photoresist can be used.

In the present description, a resist that responds to an EB is also referred to as a photoresist.

Examples of the photoresist include a positive photoresist composed of a novolac resin and **1,2-**naphthoquinonediazide sulfonic acid ester, a chemically amplified photoresist composed of a binder having a group that is decomposed by an acid to increase the alkali dissolution rate, and a photo acid generator, a chemically amplified photoresist composed of a low molecular compound that is decomposed by an acid to increase the alkali dissolution rate of the photoresist, an alkali-soluble binder, and a photo acid generator, a chemically amplified photoresist composed of a binder having a group that is decomposed by an acid to increase the alkali dissolution rate, a low molecular compound that is decomposed by an acid to increase the alkali dissolution rate of the photoresist, and a photo acid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used which include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525 A, WO 2018/190088, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A**,** JP 2012-022258 A, JP 2011-043749 A, JP 2010-181857 A, JP 2010-128369 A, WO 2018/031896, JP 2019-113855 A, WO 2017/156388, WO 2017/066319, JP 2018-41099 A, WO 2016/065120, WO 2015/026482, JP 2016-29498 A**,** JP 2011-253185 A**,** and the like, but the resist compositions are not limited thereto.

Examples of the resist composition include the following compositions.

An active ray-sensitive or radiation-sensitive resin composition that contains a resin B including a repeating unit having an acid decomposable group in which a polar group is protected by a protecting group to be removed by the action of an acid, and that contains a compound represented by General Formula (121). 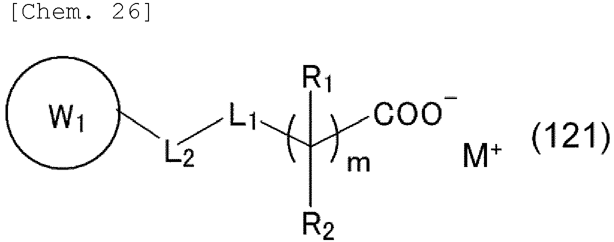
wherein m represents an integer of 1 to 6,
R₁ and R₂ each independently represent a fluorine atom or a perfluoroalkyl group,
L₁ represents -O-, -S-, -COO-, -SO₂-, or -SO₃-,
L₂ represents an alkylene group which may have a substituent, or a single bond,
W₁ represents a cyclic organic group which may have a substituent, and
M⁺ represents a cation.

A metal-containing film-forming composition for extreme ultraviolet or electron beam lithography, containing a compound having a metal-oxygen covalent bond and a solvent, in which metal elements included in the compound belong to Periods 3 to 7 of Groups 3 to 15 in the periodic table.

A radiation-sensitive resin composition that contains a polymer having a first structural unit represented by Formula (31) and a second structural unit represented by Formula (32) and containing an acid-dissociable group, and that contains an acid generator.

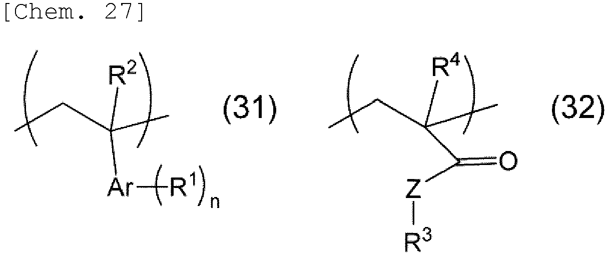

In Formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹ groups is identical or different, and R² is a hydrogen atom, a fluorine atom, a methyl group, or a trifluoromethyl group. In Formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains an acid generator and a resin (C) including a structural unit having a cyclic carbonate structure, a structural unit represented by the following formula, and a structural unit having an acid-labile group. 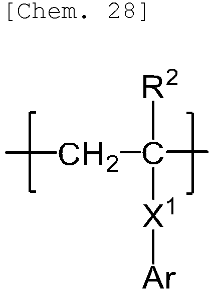 wherein
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond to -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxy group.

Examples of the resist film include the following.

A resist film containing a base resin including a repeating unit represented by Formula (a1) and/or a repeating unit represented by Formula (a2), and a repeating unit that generates an acid bonded to a polymer main chain by exposure. 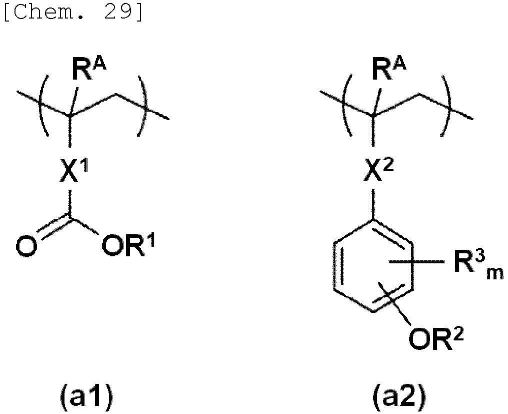 wherein each R^{A} is independently a hydrogen atom or a methyl group, R¹ and R² are each independently a tertiary alkyl group having 4 to 6 carbon atoms, Each R³ is independently a fluorine atom or a methyl group, m is an integer of 0 to 4, X¹ is a single bond, a phenylene group, a naphthylene group, or a linking group having 1 to 12 carbon atoms and including at least one selected from an ester bond, a lactone ring, a phenylene group, and a naphthylene group, and X² is a single bond, an ester bond, or an amide bond.

Examples of the resist material include the following.

A resist material containing a polymer having a repeating unit represented by Formula (b1) or (b2). 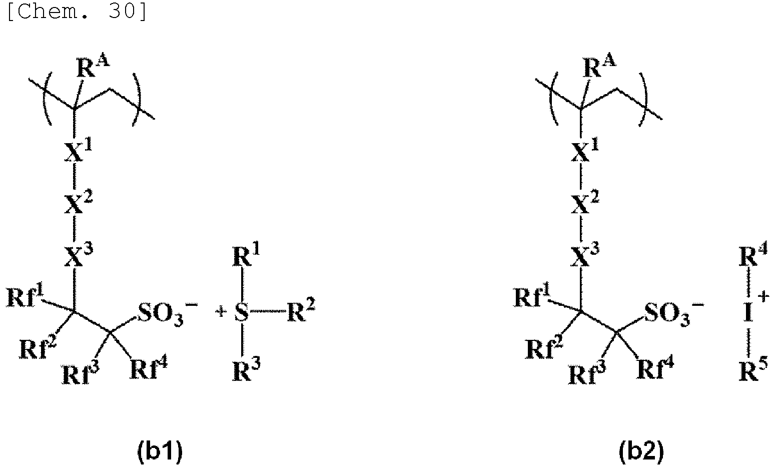 wherein R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be replaced with an ether group, an ester group, or a lactone ring-containing group, and at least one hydrogen atom included in X² is replaced with a bromine atom, X³ is a single bond, an ether group, an ester group, or a linear, branched, or cyclic alkylene group having 1 to 12 carbon atoms, and some of methylene groups included in the alkylene group may be replaced with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be replaced with a hydroxy group, a carboxy group, a halogen atom, an oxo group, a cyano group, an amide group, a nitro group, a sultone group, a sulfone group, or a sulfonium salt-containing group, and some of methylene groups included in these groups may be replaced with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by Formula (a). 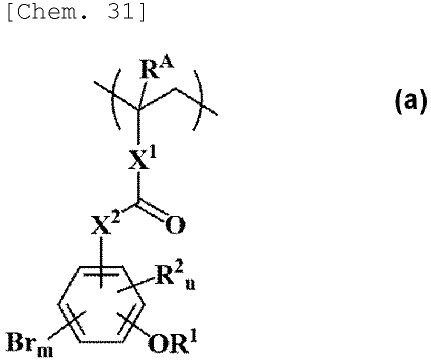 wherein R^{A} is a hydrogen atom or a methyl group, R¹ is a hydrogen atom or an acid-labile group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, -O-CH₂-, or -NH-, m is an integer of 1 to 4, and u is an integer of 0 to 3, provided that m + u is an integer of 1 to 4.

A resist composition which generates an acid by exposure and of which solubility in a developer is changed by the action of the acid, the resist composition containing:
a base material component (A) of which solubility in a developer is changed by the action of an acid and a fluorine additive component (F) which exhibits decomposability in an alkaline developer, in which
the fluorine additive component (F) contains a fluororesin component (F1) having a constituent unit (f1) containing a base-dissociable group and a constituent unit (f2) containing a group represented by General Formula (f2-r-1). 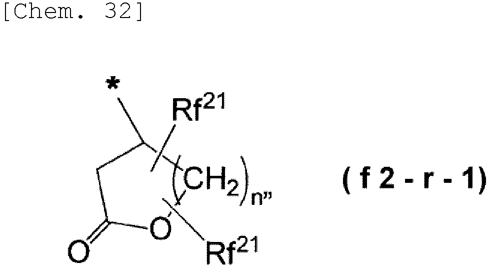
wherein each Rf²¹ is independently a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by General Formula (f1-1) or a constituent unit represented by General Formula (f1-2). 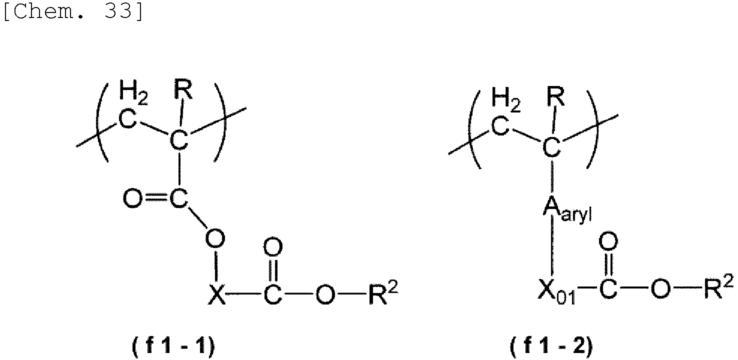 wherein each R is independently a hydrogen atom, an alkyl group having 1 to 5 carbon atoms, or a haloalkyl group having 1 to 5 carbon atoms, X is a divalent linking group not having an acid-dissociable site, A_{aryl} is a divalent aromatic ring group which may have a substituent, X₀₁ is a single bond or a divalent linking group, and each R² is independently an organic group having a fluorine atom.

The resist composition may be a metal-containing resist.

The metal-containing resist is also called a metal oxide resist (MOR), and typical examples thereof include a tin oxide-based resist.

Examples of the metal oxide resist material include a coating composition containing a metal oxo-hydroxo network having an organic ligand through a metal-carbon bond and/or a metal-carboxylate bond described in JP 2019-113855 A.

In an example of the metal-containing resist, a peroxo ligand is used as a radiation-sensitive stabilizing ligand. Details of the peroxo based metal oxo-hydroxo compounds are provided, for example, in patent literatures described in paragraph[0011] of JP 2019-532489 A. Examples of the patent literatures include US 9,176,377 B2, US 2013/0224652 A1, US 9,310,684 B2, US 2016/0116839 A1, and US 15/291738 A1.

A coating including a metal oxo-hydroxo network having an organic ligand through a metal-carbon bond and/or a metal-carboxylate bond.

An inorganic oxo-hydroxo-based composition.

A coating solution containing: an organic solvent; a first organometallic composition represented by the formula R_{z}SnO_{(2-(z/2)-(x/2))}(OH)ₓ (where 0 < z ≤ 2 and 0 < (z + x) ≤ 4), the formula R'ₙSnX₄₋ₙ (where n = 1 or 2), or a mixture thereof, wherein R and R' are independently a hydrocarbyl group having 1 to 31 carbon atoms, and X is a ligand having a hydrolyzable bond to Sn or a combination thereof; and a hydrolyzable metal compound represented by the formula MX'ᵥ (wherein M is a metal selected from Groups 2 to 16 of the element periodic table, v = a number from 2 to 6, and X' is a ligand having a hydrolyzable M-X bond or a combination thereof).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution including a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482, WO 2016/065120, WO 2017/066319, WO 2017/156388, WO 2018/031896, JP 2020-122959 A, JP 2020-122960 A, WO 2019/099981, WO 2019/199467, WO 2019/195522, WO 2019/195522, WO 2020/210660, WO 2021/011367, and WO 2021/016229.

These contents are incorporated herein to the same extent as if fully set forth.

The method for forming the metal-containing resist film from the metal-containing resist is not particularly limited, and examples thereof include a method in which a coating-type resist material as the metal-containing resist (metal-containing resist film-forming composition) is applied and baked.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as if fully set forth. In JP 2017-116923 A, the metal-containing resist film in the present invention is referred to as a metal oxide-containing film.

Irradiation with light or an electron beam is performed, for example, through a mask (reticle) for forming a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

For the development, for example, an alkaline developer or an organic solvent is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can also be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

An organic solvent can be used as a developer of the metal-containing resist, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Further, a surfactant or the like can also be added to these developers.

Subsequently, the resist underlayer film is etched using the formed resist pattern as a mask. The etching may be dry etching or wet etching, but is preferably dry etching.

When the inorganic film is formed on the surface of the semiconductor substrate used, the surface of the inorganic film is exposed, and when the inorganic film is not formed on the surface of the semiconductor substrate used, the surface of the semiconductor substrate is exposed. Thereafter, a semiconductor element can be produced through a step of processing the semiconductor substrate by a known method (dry etching method or the like).

### Examples

Hereinafter, the present invention will be described more specifically with reference to examples, but the present invention is not limited thereto.

The weight-average molecular weights of the polymers shown in the following synthesis examples are results measured by gel permeation chromatography (hereinafter, abbreviated as GPC). For the measurement, a GPC apparatus manufactured by Tosoh Corporation was used, and measurement conditions and the like are as follows.
· GPC column: Shodex KF803L, Shodex KF802, Shodex KF801 [registered trademark] (Showa Denko K.K.)
· Column temperature: 40°C
· Solvent: dimethylformamide (DMF)
· Flow rate: 1.0 ml/min
· Standard sample: polystyrene (manufactured by Tosoh Corporation)

### <Synthesis Example 1>

Into 23.67 g of propylene glycol monomethyl ether in a reaction vessel, 4.06 g of a cresol novolac type epoxy resin EOCN-104S (manufactured by Nippon Kayaku Co., Ltd.), 1.77 g of methacrylic acid (manufactured by Tokyo Chemical Industry Co., Ltd.), 0.01 g of hydroquinone (manufactured by Tokyo Chemical Industry Co., Ltd.), and 0.24 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 100°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4900 in terms of standard polystyrene. The polymer prepared in this synthesis example has a structural unit represented by Formula (1a).

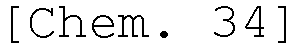

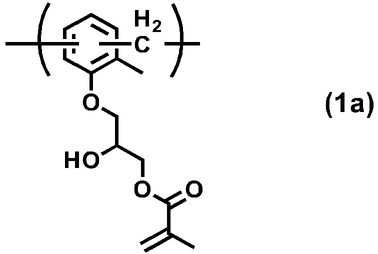

### <Synthesis Example 2>

Into 15.66 g of propylene glycol monomethyl ether in a reaction vessel, 4.06 g of a cresol novolac type epoxy resin EOCN-104S (manufactured by Nippon Kayaku Co., Ltd.), 2.51 g of sorbic acid (manufactured by Tokyo Chemical Industry Co., Ltd.), 0.09 g of hydroquinone (manufactured by Tokyo Chemical Industry Co., Ltd.), and 0.48 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 90°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 5300 in terms of standard polystyrene. The polymer prepared in this synthesis example has a structural unit represented by Formula (1b).

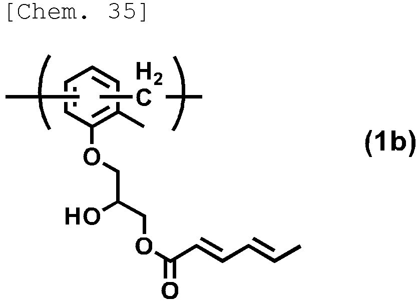

### <Synthesis Example 3>

Into 15.36 g of propylene glycol monomethyl ether in a reaction vessel, 2.96 g of an alicyclic epoxy resin NER-HM (manufactured by Finechem Inc.), 1.73 g of methacrylic acid (manufactured by Tokyo Chemical Industry Co., Ltd.), 0.01 g of hydroquinone (manufactured by Tokyo Chemical Industry Co., Ltd.), and 0.43 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4500 in terms of standard polystyrene. The polymer prepared in this synthesis example has a structural unit represented by Formula (2a). R in the formula is bonded from the carbon atom side of cyclohexane.

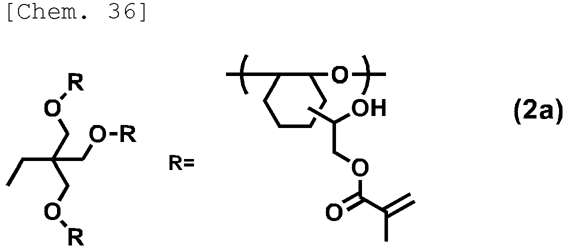

### <Synthesis Example 4>

Into 16.93 g of propylene glycol monomethyl ether in a reaction vessel, 2.96 g of an alicyclic epoxy resin NER-HM (manufactured by Finechem Inc.), 2.25 g of sorbic acid (manufactured by Tokyo Chemical Industry Co., Ltd.), 0.01 g of hydroquinone (manufactured by Tokyo Chemical Industry Co., Ltd.), and 0.43 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 5000 in terms of standard polystyrene. The polymer prepared in this synthesis example has a structural unit represented by Formula (2b). R in the formula is bonded from the carbon atom side of cyclohexane.

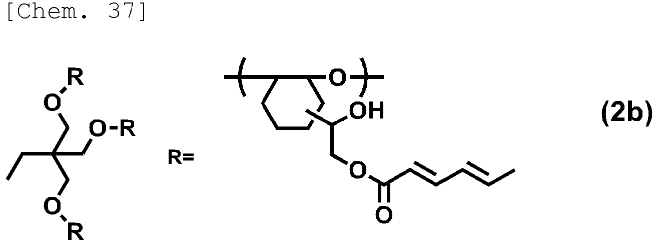

### <Synthesis Example 5>

Into 27.49 g of propylene glycol monomethyl ether acetate in a reaction vessel, 5.88 g of an alicyclic epoxy resin NER-HM (manufactured by Finechem Inc.), 5.32 g of 4-vinylbenzoic acid (manufactured by Tokyo Chemical Industry Co., Ltd.), 0.03 g of 4-hydroxy-TEMPO free radical (manufactured by Tokyo Chemical Industry Co., Ltd.), and 0.55 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4900 in terms of standard polystyrene. The polymer prepared in this synthesis example has a structural unit represented by Formula (2c). R in the formula is bonded from the carbon atom side of cyclohexane.

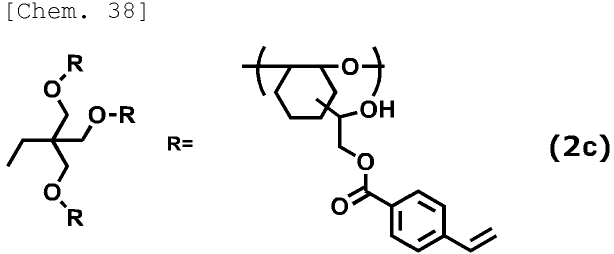

### <Synthesis Example 6>

Into 17.40 g of propylene glycol monomethyl ether acetate in a reaction vessel, 3.53 g of an alicyclic epoxy resin NER-HM (manufactured by Finechem Inc.), 3.19 g of trans-cinnamic acid (manufactured by Tokyo Chemical Industry Co., Ltd.), 0.05 g of 4-hydroxy-TEMPO free radical (manufactured by Tokyo Chemical Industry Co., Ltd.), and 0.23 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 105°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4600 in terms of standard polystyrene. The polymer prepared in this synthesis example has a structural unit represented by Formula (2d). R in the formula is bonded from the carbon atom side of cyclohexane.

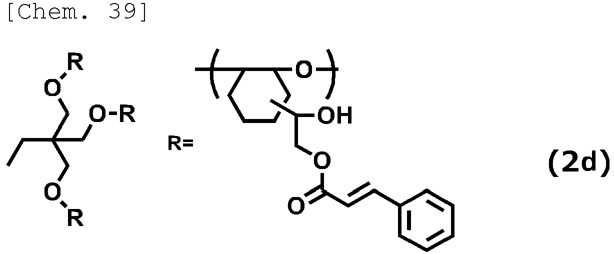

### <Synthesis Example 7>

Into 18.91 g of propylene glycol monomethyl ether acetate in a reaction vessel, 3.53 g of an alicyclic epoxy resin NER-HM (manufactured by Finechem Inc.), 3.84 g of trans-4-methoxycinnamic acid (manufactured by Tokyo Chemical Industry Co., Ltd.), 0.05 g of 4-hydroxy-TEMPO free radical (manufactured by Tokyo Chemical Industry Co., Ltd.), and 0.23 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 105°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4800 in terms of standard polystyrene. The polymer prepared in this synthesis example has a structural unit represented by Formula (2e). R in the formula is bonded from the carbon atom side of cyclohexane.

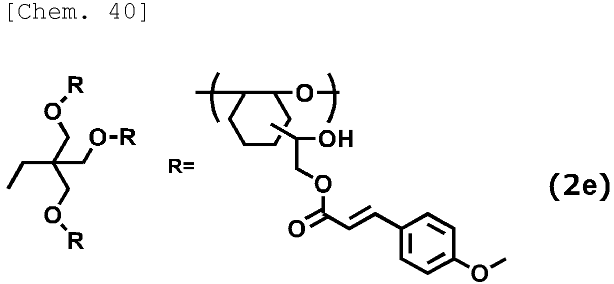

### <Synthesis Example 8>

Into 21.23 g of propylene glycol monomethyl ether acetate in a reaction vessel, 3.53 g of an alicyclic epoxy resin NER-HM (manufactured by Finechem Inc.), 4.83 g of α-phenyl cinnamic acid (manufactured by Tokyo Chemical Industry Co., Ltd.), 0.05 g of 4-hydroxy-TEMPO free radical (manufactured by Tokyo Chemical Industry Co., Ltd.), and 0.23 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 105°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4700 in terms of standard polystyrene. The polymer prepared in this synthesis example has a structural unit represented by Formula (2f). R in the formula is bonded from the carbon atom side of cyclohexane.

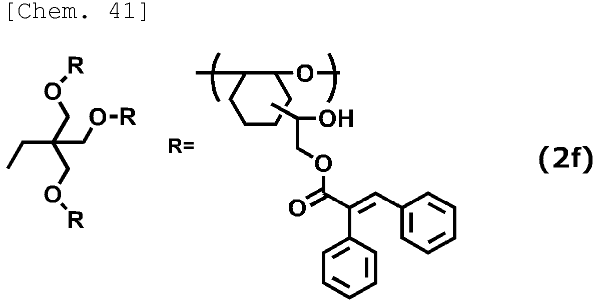

### <Synthesis Example 9>

Into 34.55 g of propylene glycol monomethyl ether acetate in a reaction vessel, 5.88 g of an alicyclic epoxy resin NER-HM (manufactured by Finechem Inc.), 2.53 g of methacrylic acid (manufactured by Tokyo Chemical Industry Co., Ltd.), 2.55 g of 3,5-diiodosalicylic acid (manufactured by Tokyo Chemical Industry Co., Ltd.), 0.08 g of 4-hydroxy-TEMPO free radical (manufactured by Tokyo Chemical Industry Co., Ltd.), and 0.55 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 105°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4400 in terms of standard polystyrene. The polymer prepared in this synthesis example has a structural unit represented by Formula (2g). R in the formula is bonded from the carbon atom side of cyclohexane.

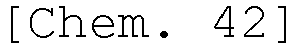

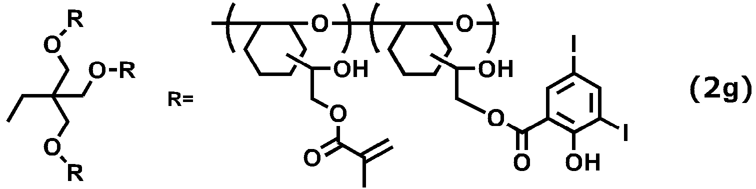

### <Synthesis Example 10>

Into 36.70 g of propylene glycol monomethyl ether acetate in a reaction vessel, 5.88 g of an alicyclic epoxy resin NER-HM (manufactured by Finechem Inc.), 2.53 g of methacrylic acid (manufactured by Tokyo Chemical Industry Co., Ltd.), 3.26 g of 2,3,5-triiodobenzoic acid (manufactured by Tokyo Chemical Industry Co., Ltd.), 0.08 g of 4-hydroxy-TEMPO free radical (manufactured by Tokyo Chemical Industry Co., Ltd.), and 0.55 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 105°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4400 in terms of standard polystyrene. The polymer prepared in this synthesis example has a structural unit represented by Formula (2h). R in the formula is bonded from the carbon atom side of cyclohexane.

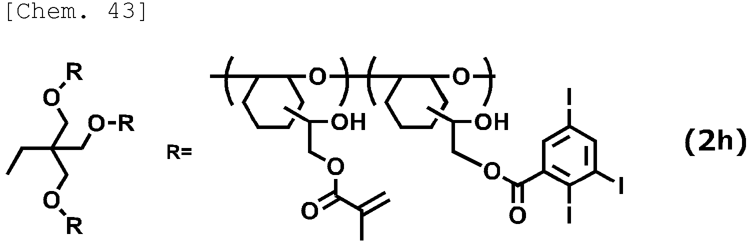

### <Synthesis Example 11>

Into 25.63 g of propylene glycol monomethyl ether acetate in a reaction vessel, 5.98 g of a cresol novolac type epoxy resin EOCN-104S (manufactured by Nippon Kayaku Co., Ltd.), 4.51 g of 4-vinylbenzoic acid (manufactured by Tokyo Chemical Industry Co., Ltd.), 0.02 g of 4-hydroxy-TEMPO free radical (manufactured by Tokyo Chemical Industry Co., Ltd.), and 0.47 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 5300 in terms of standard polystyrene. The polymer prepared in this synthesis example has a structural unit represented by Formula (1c).

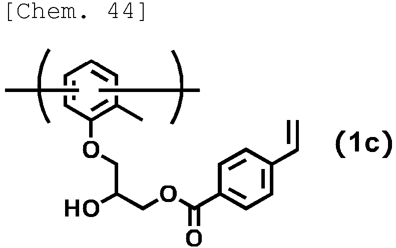

### <Synthesis Example 12>

Into 28.75 g of propylene glycol monomethyl ether acetate in a reaction vessel, 5.98 g of a cresol novolac type epoxy resin EOCN-104S (manufactured by Nippon Kayaku Co., Ltd.), 3.69 g of 4-vinylbenzoic acid (manufactured by Tokyo Chemical Industry Co., Ltd.), 2.16 g of 3,5-diiodosalicylic acid (manufactured by Tokyo Chemical Industry Co., Ltd.), 0.02 g of a 4-hydroxy-TEMPO free radical (manufactured by Tokyo Chemical Industry Co., Ltd.), and 0.47 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4900 in terms of standard polystyrene. The polymer prepared in this synthesis example has a structural unit represented by Formula (1d).

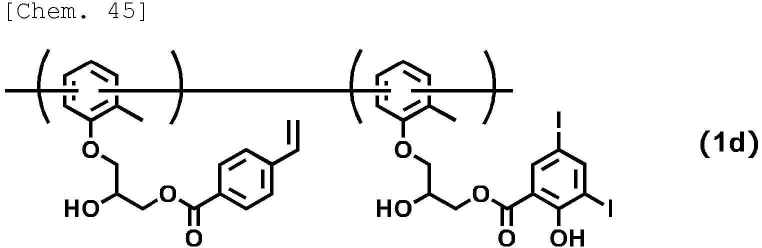

### <Synthesis Example 13>

Into 30.17 g of propylene glycol monomethyl ether acetate in a reaction vessel, 5.98 g of a cresol novolac type epoxy resin EOCN-104S (manufactured by Nippon Kayaku Co., Ltd.), 3.69 g of 4-vinylbenzoic acid (manufactured by Tokyo Chemical Industry Co., Ltd.), 2.76 g of 2,3,5-triiodobenzoic acid (manufactured by Tokyo Chemical Industry Co., Ltd.), 0.02 g of a 4-hydroxy-TEMPO free radical (manufactured by Tokyo Chemical Industry Co., Ltd.), and 0.47 g of tetrabutylphosphonium bromide (manufactured by HOKKO CHEMICAL INDUSTRY CO., LTD.) were added and dissolved. The reaction vessel was purged with nitrogen, and then a reaction was allowed to proceed at 85°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 4700 in terms of standard polystyrene. The polymer prepared in this synthesis example has a structural unit represented by Formula (1e).

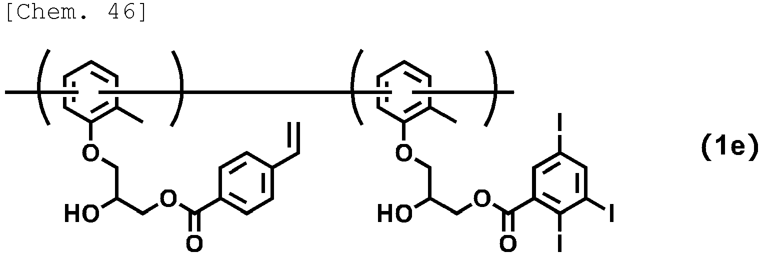

### <Synthesis Example 14>

Into 21 g of propylene glycol monomethyl ether acetate and 32 g of propylene glycol monomethyl ether in a reaction vessel, 10.00 g of poly(glycidyl methacrylate) (manufactured by Maruzen Petrochemical Co., Ltd.), 2.38 g of propionic acid (manufactured by Tokyo Chemical Industry Co., Ltd.), and 0.21 g of tetrabutylphosphonium bromide (manufactured by ACROSS) were added and dissolved. The reaction vessel was purged with nitrogen, and then a reaction was allowed to proceed at 80°C for 24 hours to prepare a polymer solution. The polymer solution did not become cloudy even when cooled to room temperature, and had good solubility in a mixed solvent of propylene glycol monomethyl ether/propylene glycol monomethyl ether acetate. The polymer in the prepared polymer solution was subjected to GPC analysis, and was found to have a weight-average molecular weight of 10426 in terms of standard polystyrene. The polymer prepared in this synthesis example has a structural unit represented by Formula (3a).

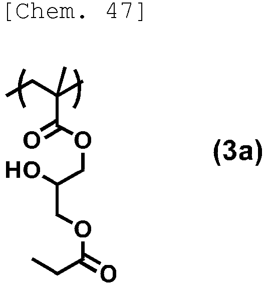

### <Synthesis Example 15>

In 682 g of propylene glycol monomethyl ether, 100 g of monoallyl diglycidyl isocyanurate (manufactured by SHIKOKU CHEMICALS CORPORATION), 66.4 g of 5,5-diethylbarbituric acid, and 4.1 g of benzyltriethylammonium chloride were dissolved, and then a reaction was allowed to proceed at 130°C for 24 hours to obtain a solution containing a polymer. The prepared polymer was subjected to GPC analysis, and was found to have a weight-average molecular weight of 6800 in terms of standard polystyrene. The prepared polymer is considered to be a polymer having the structure of Formula (3b) as a repeating unit structure.

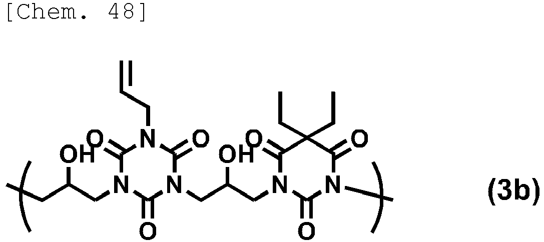

### [Example 1]

Into 0.388 g of the polymer solution (solid content: 17.57%) prepared in Synthesis Example 1, 0.0171 g of tetramethoxymethyl glycoluril (manufactured by Nihon Cytec Industries Inc.), 0.171 g of a 1% solution of pyridinium toluenesulfonate in propylene glycol monomethyl ether, 26.43 g of propylene glycol monomethyl ether, and 2.99 g of propylene glycol monomethyl ether acetate were added and dissolved. Thereafter, the mixture was filtered using a polyethylene microfilter having a pore size of 0.05 µm to form a resist underlayer film-forming composition.

### [Example 2]

Into 0.173 g of the polymer solution (solid content: 24.48%) prepared in Synthesis Example 2, 0.0106 g of tetramethoxymethyl glycoluril (manufactured by Nihon Cytec Industries Inc.), 0.106 g of a 1% solution of pyridinium toluenesulfonate in propylene glycol monomethyl ether, 26.72 g of propylene glycol monomethyl ether, and 2.99 g of propylene glycol monomethyl ether acetate were added and dissolved. Thereafter, the mixture was filtered using a polyethylene microfilter having a pore size of 0.05 µm to form a resist underlayer film-forming composition.

### [Example 3]

Into 0.355 g of the polymer solution (solid content: 19.22%) prepared in Synthesis Example 3, 0.0171 g of tetramethoxymethyl glycoluril (manufactured by Nihon Cytec Industries Inc.), 0.171 g of a 1% solution of pyridinium toluenesulfonate in propylene glycol monomethyl ether, 26.47 g of propylene glycol monomethyl ether, and 2.99 g of propylene glycol monomethyl ether acetate were added and dissolved. Thereafter, the mixture was filtered using a polyethylene microfilter having a pore size of 0.05 µm to form a resist underlayer film-forming composition.

### [Example 4]

Into 0.240 g of the polymer solution (solid content: 17.63%) prepared in Synthesis Example 4, 0.0106 g of tetramethoxymethyl glycoluril (manufactured by Nihon Cytec Industries Inc.), 0.106 g of a 1% solution of pyridinium toluenesulfonate in propylene glycol monomethyl ether, 26.65 g of propylene glycol monomethyl ether, and 2.99 g of propylene glycol monomethyl ether acetate were added and dissolved. Thereafter, the mixture was filtered using a polyethylene microfilter having a pore size of 0.05 µm to form a resist underlayer film-forming composition.

### [Example 5]

Into 0.3551 g of the polymer solution (solid content: 21.12%) prepared in Synthesis Example 5, 0.0187 g of tetramethoxymethyl glycoluril (manufactured by Nihon Cytec Industries Inc.), 0.874 g of a 1% solution of pyridinium toluenesulfonate in propylene glycol monomethyl ether, 102.55 g of propylene glycol monomethyl ether, and 43.57 g of propylene glycol monomethyl ether acetate were added and dissolved. Thereafter, the mixture was filtered using a polyethylene microfilter having a pore size of 0.05 µm to form a resist underlayer film-forming composition.

### [Example 6]

Into 1.5720 g of the polymer solution (solid content: 14.68%) prepared in Synthesis Example 6, 0.0577 g of tetramethoxymethyl glycoluril (manufactured by Nihon Cytec Industries Inc.), 0.5769 g of a 1% solution of pyridinium toluenesulfonate in propylene glycol monomethyl ether, 44.67 g of propylene glycol monomethyl ether, and 4.88 g of propylene glycol monomethyl ether acetate were added and dissolved. Thereafter, the mixture was filtered using a polyethylene microfilter having a pore size of 0.05 µm to form a resist underlayer film-forming composition.

### [Example 7]

Into 1.4946 g of the polymer solution (solid content: 15.44%) prepared in Synthesis Example 7, 0.0577 g of tetramethoxymethyl glycoluril (manufactured by Nihon Cytec Industries Inc.), 0.5769 g of a 1% solution of pyridinium toluenesulfonate in propylene glycol monomethyl ether, 44.67 g of propylene glycol monomethyl ether, and 4.88 g of propylene glycol monomethyl ether acetate were added and dissolved. Thereafter, the mixture was filtered using a polyethylene microfilter having a pore size of 0.05 µm to form a resist underlayer film-forming composition.

### [Example 8]

Into 1.4987 g of the polymer solution (solid content: 15.70%) prepared in Synthesis Example 8, 0.0588 g of tetramethoxymethyl glycoluril (manufactured by Nihon Cytec Industries Inc.), 0.5882 g of a 1% solution of pyridinium toluenesulfonate in propylene glycol monomethyl ether, 103.09 g of propylene glycol monomethyl ether, and 43.64 g of propylene glycol monomethyl ether acetate were added and dissolved. Thereafter, the mixture was filtered using a polyethylene microfilter having a pore size of 0.05 µm to form a resist underlayer film-forming composition.

### [Example 9]

Into 2.711 g of the polymer solution (solid content: 14.86%) prepared in Synthesis Example 9, 0.1003 g of tetramethoxymethyl glycoluril (manufactured by Nihon Cytec Industries Inc.), 1.0073 g of a 1% solution of pyridinium toluenesulfonate in propylene glycol monomethyl ether, 41.8675 g of propylene glycol monomethyl ether, and 102.2733 g of propylene glycol monomethyl ether acetate were added and dissolved. Thereafter, the mixture was filtered using a polyethylene microfilter having a pore size of 0.05 µm to form a resist underlayer film-forming composition.

### [Example 10]

Into 2.7161 g of the polymer solution (solid content: 15.16%) prepared in Synthesis Example 10, 0.1029 g of tetramethoxymethyl glycoluril (manufactured by Nihon Cytec Industries Inc.), 1.0294 g of a 1% solution of pyridinium toluenesulfonate in propylene glycol monomethyl ether, 41.8675 g of propylene glycol monomethyl ether, and 102.2733 g of propylene glycol monomethyl ether acetate were added and dissolved. Thereafter, the mixture was filtered using a polyethylene microfilter having a pore size of 0.05 µm to form a resist underlayer film-forming composition.

### [Comparative Example 1]

Into 0.354 g of the polymer solution (solid content: 19.41%) prepared in Synthesis Example 14, 0.0106 g of tetramethoxymethyl glycoluril (manufactured by Nihon Cytec Industries Inc.), 0.106 g of a 1% solution of pyridinium toluenesulfonate in propylene glycol monomethyl ether, 26.69 g of propylene glycol monomethyl ether, and 2.99 g of propylene glycol monomethyl ether acetate were added and dissolved. Thereafter, the mixture was filtered using a polyethylene microfilter having a pore size of 0.05 µm to form a resist underlayer film-forming composition.

### [Comparative Example 2]

Into 0.427 g of the polymer solution (solid content: 15.98%) prepared in Synthesis Example 15, 0.0171 g of tetramethoxymethyl glycoluril (manufactured by Nihon Cytec Industries Inc.), 0.171 g of a 1% solution of pyridinium toluenesulfonate in propylene glycol monomethyl ether, 20.41 g of propylene glycol monomethyl ether, and 8.97 g of propylene glycol monomethyl ether acetate were added and dissolved. Thereafter, the mixture was filtered using a polyethylene microfilter having a pore size of 0.05 µm to form a resist underlayer film-forming composition.

### [Elution Test in Photoresist Solvent]

Each of the resist underlayer film-forming compositions of Examples 1 to 10 and Comparative Examples 1 and 2 was applied onto a silicon wafer as a semiconductor substrate with a spinner. The silicon wafers were disposed on a hot plate and baked at 215°C for 1 minute to form resist underlayer films (film thickness: 5 nm). These resist underlayer films were immersed in propylene glycol monomethyl ether/propylene glycol monomethyl ether acetate (mass ratio = 7/3), which is a solvent used for the photoresist, and were confirmed to be insoluble in these solvents.

### [Formation of Resist Pattern by EUV Exposure: Negative Development with Organic Solvent]

Each of the resist underlayer film-forming compositions of Example 1, Example 2, Example 3, Example 4, Comparative Example 1, and Comparative Example 2 was applied onto a silicon wafer using a spinner. The silicon wafers were baked on a hot plate at 215°C for 60 seconds to form resist underlayer films having a film thickness of 5 nm. A resist solution for EUV (tin oxide-based resist) was applied onto each of the resist underlayer films by spin coating, and heated at 130°C for 1 minute to form an EUV resist layer and thereafter, the EUV resist layer was exposed using an EUV exposure apparatus (NXE3400) manufactured by ASML under the conditions of NA = 0.33, σ = 0.60/0.82 (outer/inner), and Dipole. At the time of exposure, exposure was performed through a mask designed such that the line width and the inter-line width (space width) of the EUV resist were 14 nm after the following development, that is, a 14 nm line-and-space (L/S) =1/1 dense line was formed.

After the exposure, post exposure baking (PEB, 180°C for 1 min) was performed, followed by cooling to room temperature on a cooling plate, and then the resist layer was developed for 60 seconds using an organic solvent (propylene glycol monomethyl ether acetate), and rinsed to form a resist pattern.

Using a Critical Dimension-Scanning Electron Microscope (SEM, CG4100) manufactured by Hitachi High-Technologies Corporation, the exposure amount at the time of formation with a line dimension of 14 nm was measured and taken as sensitivity, and the minimum pattern size formed without pattern peeling and collapse was taken as MinCD. In the formation of the resist patterns, the values of the line width roughness (LWR) with a CD size of 14 nm were compared. In addition, the Z-factor represented by Formula (I) was calculated as an index for comprehensively evaluating the performance of the resist. The smaller the values of sensitivity, MinCD, LWR, and Z-factor are, the better the resist performance **is.** The results are shown in Table 1. $Z - factor = {\left(MinCD\right)}^{3} \times {\left(LWR\right)}^{2} \times \left(sensitivity\right)$ (I)

**[Table 1]**

| | Sensitivity (mJ/cm²) | MinCD (nm) | LWR (nm) | Z-factor (mJnm³) |
|---|---|---|---|---|
| Example 1 | 66.5 | 11.2 | 3.00 | 8.4 × 10⁻⁹ |
| Example 2 | 66.9 | 11.3 | 3.00 | 8.7 × 10⁻⁹ |
| Example 3 | 63.1 | 10.4 | 3.12 | 6.9 × 10⁻⁹ |
| Example 4 | 61.9 | 10.1 | 3.12 | 6.2 × 10⁻⁹ |
| Comparative Example 1 | 67.5 | 11.4 | 3.15 | 9.9 × 10⁻⁹ |
| Comparative Example 2 | 68.7 | 11.8 | 3.13 | 11.0 × 10⁻⁹ |

As shown in Table 1, Examples 1 to 4 to which the present invention was applied were found to be superior in sensitivity and resolution (MinCD, LWR, Z-factor) to Comparative Example 1 in which the polymer did not contain a polymerizable multiple bond and Comparative Example 2 in which the polymer did not have a specific ring structure.

## Claims

1. A resist underlayer film-forming composition comprising a resin (A) having a ring structure and a polymerizable multiple-bond group and a solvent, wherein
the ring structure is one or more selected from the group consisting of an aromatic ring having 6 to 26 carbon atoms and a non-aromatic ring having 6 to 10 carbon atoms, and
the polymerizable multiple-bond group has one or more selected from the group consisting of a carbon-carbon double bond, a carbon-carbon triple bond, a carbon-nitrogen double bond, and a carbon-nitrogen triple bond.

2. The resist underlayer film-forming composition according to claim **1,** wherein in the resin (A), the polymerizable multiple-bond group is bonded to the ring structure by a reaction between an epoxy group and a nucleophilic functional group.

3. The resist underlayer film-forming composition according to claim **2,** wherein the nucleophilic functional group is one or more selected from the group consisting of a carboxy group, a hydroxy group, an amino group, and a thiol group.

4. The resist underlayer film-forming composition according to claim 1, wherein the resin (A) includes at least one of a partial structure represented by Formula (1) as a partial structure having the polymerizable multiple-bond group, or a partial structure represented by Formula (2) or (3) as a partial structure having the ring structure and the polymerizable multiple-bond group, 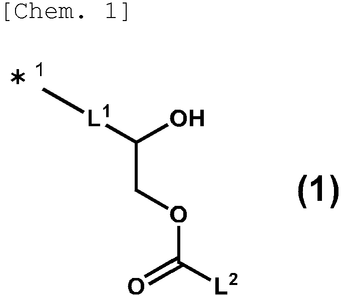 wherein L¹ represents a single bond, -O-CH₂-, -CH₂-O-, -CH₂-O-CH₂-, -CH₂-O-CO-, or -CO-O-CH₂-, L² represents a monovalent polymerizable multiple-bond group, and *¹ represents a bond that is bonded to the ring structure, and 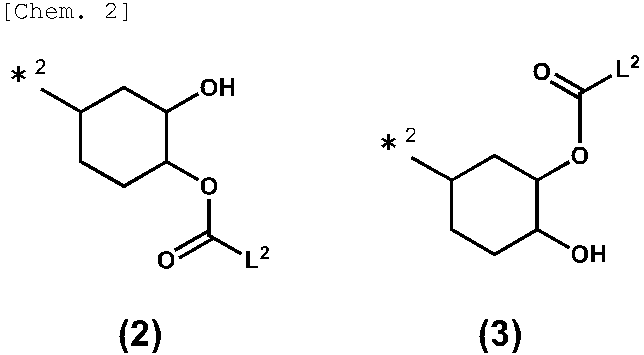 wherein L² represents a monovalent polymerizable multiple-bond group, and *² represents a bond.

5. The resist underlayer film-forming composition according to claim 4, wherein the L² is an alkenyl group having 3 to 5 carbon atoms or a hydrocarbon group having 4 to 5 carbon atoms and having two carbon-carbon double bonds.

6. The resist underlayer film-forming composition according to claim 1, further comprising a crosslinking agent.

7. The resist underlayer film-forming composition according to claim 1, further comprising an acid generator.

8. A resist underlayer film that is a cured product of the resist underlayer film-forming composition according to any one of claims 1 to 7.

9. A laminate comprising:
a semiconductor substrate; and
the resist underlayer film according to claim 8.

10. A method for producing a semiconductor element, the method comprising the steps of:
forming a resist underlayer film on a semiconductor substrate using the resist underlayer film-forming composition according to any one of claims 1 to **7;** and
forming a resist film on the resist underlayer film.

11. A method for forming a pattern, the method comprising the steps of:
forming a resist underlayer film on a semiconductor substrate using the resist underlayer film-forming composition according to any one of claims 1 to **7;**
forming a resist film on the resist underlayer film;
irradiating the resist film with light or an electron beam, and then developing the resist film to obtain a resist pattern; and
etching the resist underlayer film using the resist pattern as a mask.
